# EUROPEAN PATENT APPLICATION

(11) **EP 3 611 839 A1**
(43) Date of publication of application: **19.02.2020**
(21) Application number: 19189997.0
(22) Date of filing: 05.08.2019
(51) Int. Cl.: H03F 1/56, H01L 23/66, H03F 3/195, H03F 3/24, H01L 25/00

(54) **AMPLIFIERS WITH BROADBAND IMPEDANCE MATCHING AND METHODS OF MANUFACTURE THEREOF**

(30) Priority: 14.08.2018 US 201816103717
(71) Applicant: NXP USA, Inc., Austin TX 78735 (US)
(72) Inventor: KAHLOON, Ijaz, 5656 AG Eindhoven (NL); BRAKENSIEK, Warren Henry, 5656 AG Eindhoven (NL)
(74) Representative: Lee, Candice Jane

(57) **Abstract**

The embodiments described herein provide radio frequency (RF) amplifiers, and in some embodiments provide amplifiers that can be used in high power RF applications. Specifically, the amplifiers described herein may be implemented to include one or more matching networks (104, 404) with the transistor(s) and inside the device package in a way that may facilitate operation at high frequencies and over wide bandwidths. Specifically, the amplifiers can be implemented with matching networks (104, 404) that include inductive and capacitive elements arranged in double T-match configuration, where at least some inductive elements are implemented with bond wires and the capacitive elements are implemented with integrated passive devices (IPDs). In such implementations the double T-match configuration of the matching network can be fully implemented inside the package, and may provide the amplifier with high frequency, wide bandwidth performance.

## Description

### TECHNICAL FIELD

Embodiments of the subject matter described herein relate generally to radio frequency (RF) amplifiers, and more particularly to broadband power transistor devices and amplifiers, and methods of manufacturing such devices and amplifiers.

### BACKGROUND

Many systems employ power amplifiers for increasing the power of radio frequency (RF) signals. For example, in both radar and wireless communication systems high power RF amplifiers may form a portion of the last amplification stage in a transmission chain before provision of the amplified signal to an antenna for radiation over the air interface. High bandwidth, high gain, high linearity, stability, and a high level of power-added efficiency can be characteristics of a desirable high power RF amplifier in such systems.

To achieve these goals in some high power RF amplifier applications there is a need for uniform impedance over a relatively wide frequency bandwidth. Achieving such uniform impedance over a wide frequency bandwidth is increasing difficult as device periphery and frequency increase. For example, the internal capacitances of large, high power transistors can have significant variations over wide frequency bandwidths, especially at high frequencies over 3.0 gigahertz (GHz). These variations in internal capacitances can make it difficult to achieve uniform output impedance over the wide frequency band. As one specific example, the drain-source capacitance of a high power field effect transistor (FET) can experience significant increase over a desired frequency band in a way that cannot be compensated for using traditional matching techniques. This variation in intrinsic capacitance can thus effectively prevent an amplifier using such a FET from providing uniform output impedance over the desired bandwidth. Thus, there remains a continuing need for improved amplifiers that can provide high power output at high frequencies and over a wide frequency bandwidth.

### SUMMARY

According to first aspect, there is provided an amplifier comprising: a device package including at least a first output lead and at a first input lead, the device package encasing: a first transistor die, wherein the first transistor die includes a first transistor, a first input terminal, and a first output terminal; and a first output matching network coupled between the first output terminal and the first output lead, the first output matching network including a first output inductive element, a second output inductive element, a third output inductive element, a first output capacitance, and a second output capacitance arranged in a double T-match configuration, wherein each of the first output inductive element and the third output inductive element are implemented with bond wires inside the device package, and wherein the first output capacitance and second output capacitance are implemented with integrated passive devices (IPDs) on an output IPD die inside the device package.
he amplifier of claim 1, wherein the double T-match configuration comprises the first output inductive element, the second output inductive element, and the third output inductive element in series, the first output capacitance configured in a first shunt and between the first output inductive element and the second output inductive element, and the second output capacitance configured in a second shunt and between the second output inductive element and the third output inductive element.

The second output inductive element may be implemented with bond wires inside the device package. The second output inductive element may be implemented with an integrated inductor on the output IPD die. The first output capacitance may be implemented with one or more first metal-insulator-metal (MIM) capacitors and wherein the second output capacitance is implemented with one or more second MIM capacitors. The first output matching network may further comprise a fourth output inductive element and a third output capacitance arranged in bond-back configuration, and wherein the fourth output inductive element may be implemented with a bond wire inside the device package and wherein the third output capacitance may be implemented with an integrated passive device (IPD) on the output IPD die inside the device package. The fourth output inductive element and the third output capacitance may be configured to resonate at a frequency above a fundamental frequency and below a second harmonic frequency.

The amplifier may further comprise an input matching network coupled between the first input terminal and the first input lead, the input matching network including a first input inductive element, a second input inductive element, a third input inductive element, a first input capacitance and a second input capacitance arranged in a double T-match configuration, wherein each of the first input inductive element and the third input inductive element are implemented with bond wires inside the device package, and wherein the first capacitance and second capacitance are implemented with integrated passive devices (IPDs) on an input IPD die inside the device package. The second input inductive element may be implemented with bond wires inside the device package. The second input inductive element may be implemented with an integrated inductor on the input IPD die. The transistor may comprise a gallium nitride (GaN) field-effect transistor (FET).

The amplifier may further comprise: a second output lead on the device package; a second transistor die, wherein the second transistor die includes a second transistor, a second input terminal, and a second output terminal; and a second output matching network coupled between the second output terminal and the second output lead, the second output matching network including a first output inductive element, a second output inductive element, a third output inductive element, a first output capacitance and a second output capacitance arranged in a double T-match configuration, wherein each of the first output inductive element, the second output inductive element and the third output inductive element are implemented with bond wires inside the device package, and wherein the first output capacitance and second output capacitance are implemented with integrated passive devices (IPDs) on a second output IPD die inside the device package.

According to a second aspect, there is provided a packaged radio frequency (RF) amplifier comprising: a package substrate; a first input lead coupled to the package substrate; a first output lead coupled to the package substrate; a first transistor die coupled to the package substrate, wherein the first transistor die includes a first transistor, a first input terminal, and a first output terminal; a first input matching network coupled between the first input lead and the first input terminal, the first input matching network including: a first input inductive element, a second input inductive element, a third input inductive element, a first input capacitance and a second input capacitance arranged in a double T-match configuration, wherein each of the first input inductive element, the second input inductive element and the third input inductive element are implemented with bond wires, and wherein the first capacitance and second capacitance are implemented with integrated metal-insulator-metal (MIM) capacitors formed on an input integrated passive device (IPD) die coupled to the package substrate; and a first output matching network coupled between the first output terminal and the first output lead, the first output matching network including: a first output inductive element, a second output inductive element, a third output inductive element, a first output capacitance and a second output capacitance arranged in a double T-match configuration, wherein each of the first output inductive element, the second output inductive element and the third output inductive element are implemented with bond wires, and wherein the first output capacitance and second output capacitance are implemented with integrated metal-insulator-metal (MIM) capacitors formed on an output integrated passive device (IPD) die coupled to the package substrate.

The first output matching network further may comprise a fourth output inductive element and a third output capacitance arranged in bond-back configuration, and wherein the fourth output inductive element is implemented with bond wires, and wherein the third output capacitance is implemented with one or more MIM capacitors on the output IPD die coupled to the package substrate.

According to a third aspect, there is provided a method of manufacturing a radio frequency (RF) amplifier device, the method comprising the steps of: coupling a first input lead to a package substrate; coupling a first output lead to the package substrate; coupling a first transistor die coupled to the package substrate, wherein the first transistor die includes a first transistor, a first input terminal, and a first output terminal; coupling an integrated passive device to the package substrate between the transistor die and the first output lead, wherein the integrated passive device includes a first output capacitance and a second output capacitance, wherein the first output capacitance includes one or more first capacitors that are integrally formed with the integrated passive device and the second output capacitance includes one or more second capacitors that are integrally formed with the integrated passive device; and creating an output matching network coupled between the first output terminal and the first output lead by connecting a first output inductive element, a second output inductive element, and a third output inductive element to the first output capacitance and the second output capacitance in a double T-match configuration, wherein each of the first output inductive element and the third output inductive element are implemented with bond wires.

The double T-match configuration may comprise the first output inductive element, the second output inductive element, and the third output inductive element in series, the first output capacitance configured in a first shunt and between the first output inductive element and the second output inductive element, and the second output capacitance configured in a second shunt and between the second output inductive element and the third output inductive element. The second output inductive element may be implemented with at least one of bond wires and an integrated inductor on the output IPD die. The method of claim 16, wherein the one or more first capacitors are first metal-insulator-metal (MIM) capacitors and wherein the one or more second capacitors are second MIM capacitors. The integrated passive device may further include a third output capacitance, wherein the third output capacitance includes one or more third capacitors that are integrally formed with the integrated passive device, and wherein the output matching network further comprises a fourth output inductive element implemented with bond wires, and wherein the third output capacitance and the fourth output inductive element are coupled to the output lead and arranged in bond-back configuration.

The method may further comprise the steps of: coupling an input integrated passive device to the package substrate between the transistor die and the first input lead, wherein the input integrated passive device includes a first input capacitance and a second input capacitance, wherein the first input capacitance includes one or more first input capacitors that are integrally formed with the input integrated passive device and the second output capacitance includes one or more second input capacitors that are integrally formed with the input integrated passive device; and creating an input matching network coupled between the first input terminal and the first input lead by connecting a first input inductive element, a second input inductive element, and a third input inductive element to the first input capacitance and the second input capacitance in a double T-match configuration, wherein each of the first input inductive element and the third input inductive element are implemented with bond wires. The second input inductive element may be implemented with at least one of bond wires and an integrated inductor on the input IPD die.

The method may further comprise the steps of: coupling a second input lead to a package substrate; coupling a second output lead coupled to the package substrate; coupling a second transistor die coupled to the package substrate, wherein the second transistor die includes a second transistor, a second input terminal, and a second output terminal; coupling a second integrated passive device to the package substrate between the second transistor die and the second output lead, wherein the second integrated passive device includes a first output capacitance and a second output capacitance, wherein the first output capacitance includes one or more first capacitors that are integrally formed with the second integrated passive device and the second output capacitance includes one or more second capacitors that are integrally formed with the second integrated passive device; and creating a second output matching network coupled between the second output terminal and the second output lead by connecting a first output inductive element, a second output inductive element, and a third output inductive element to the first output capacitance and the second output capacitance in a double T-match configuration, wherein each of the first output inductive element, the second output inductive element and the third output inductive element are implemented with bond wires.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a schematic diagram of an amplifier device in accordance with an exemplary embodiment;
FIGS 2-3 are circuit diagrams of amplifiers in accordance with various exemplary embodiments;
FIG. 4 is a schematic diagram of an amplifier device in accordance with an exemplary embodiment;
FIG. 5 is a circuit diagram of an amplifier in accordance with an exemplary embodiment;
FIG. 6 is a schematic view of an RF power amplifier device that includes multiple parallel amplification paths in accordance with an example embodiment;
FIG. 7 is a top view of a packaged RF power amplifier device that includes multiple parallel amplification paths in accordance with an example embodiment;
FIG. 8 is a schematic view of an integrated passive device that includes metal-insulator-metal capacitors in accordance with an example embodiment;
FIG. 9 is a Smith Chart representation of impedances associated with an example embodiment;
FIGS. 10A-10D are graphical views of exemplary amplifier performance parameters over a bandwidth in accordance with another example embodiment; and
FIG. 11 is a flowchart of a method for fabricating a packaged RF power amplifier device in accordance with an example embodiment.

### DETAILED DESCRIPTION

The embodiments described herein provide radio frequency (RF) amplifiers, and in some embodiments provide amplifiers that can be used in high power RF applications. Specifically, the amplifiers described herein may be implemented to include one or more matching networks with the transistor(s) and inside the device package in a way that may facilitate good performance at high frequencies and over wide bandwidths. Specifically, the amplifiers can be implemented with matching networks that include inductive and capacitive elements arranged in a double T-match configuration, where at least some inductive elements are implemented with bond wires and the capacitive elements are implemented with integrated passive devices (IPDs). In such implementations the double T-match configuration of the matching network can be fully implemented inside the package, and may provide the amplifier with high frequency, wide bandwidth performance.

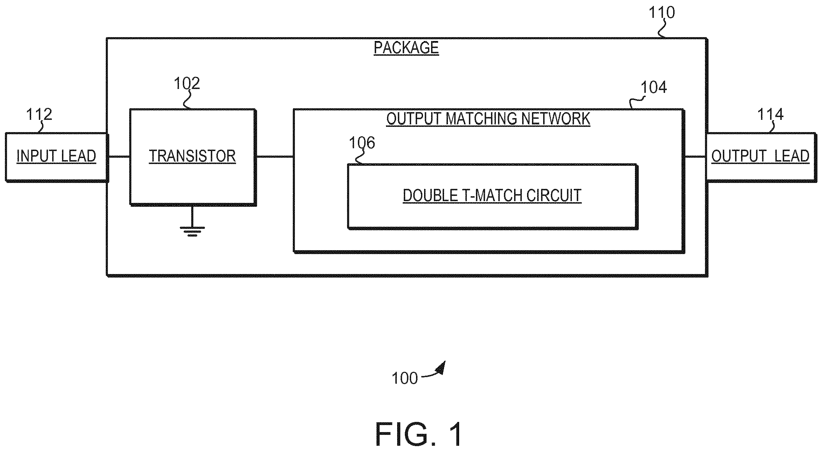

Turning now to FIG. 1, a schematic diagram of a portion of an exemplary amplifier 100 is illustrated. The amplifier 100 includes a first transistor 102, a first output matching network 104 that includes a double T-match circuit 106, and a package 110 that includes a first input lead 112 and a first output lead 114.

In accordance with the embodiments described herein, the transistor 102 is packaged with the output matching network 104. Specifically, the transistor 102 is formed on a transistor die, and that transistor die typically includes a first input terminal (e.g., a gate control terminal) and a first output terminal (e.g., a current conducting terminal) that are used to connect to the transistor 102. In one specific embodiment, the transistor 102 comprises a gallium nitride (GaN) field-effect transistor (FET), but other transistor types can also be used. As more specific examples, various III-V field effect transistors (e.g., a high electron mobility transistor (HEMT)), such as a GaN FET (or another type of III-V transistor, including a gallium arsenide (GaAs) FET, a gallium phosphide (GaP) FET, an indium phosphide (InP) FET, or an indium antimonide (InSb) FET) may be used. In other examples the transistor 102 may be implemented with a III-V FET or with a silicon-based FET (e.g., a laterally-diffused metal oxide semiconductor (LDMOS) FET).

The output matching network 104 includes the double T-match circuit 106, where the double T-match circuit 106 includes at least a first output inductive element, a second output inductive element, a third output inductive element, a first output capacitance, and a second output capacitance. In accordance with the embodiments described herein, each of the first output inductive element and the third output inductive element are implemented with bond wires inside the device package 110, and each of the first output capacitance and second output capacitance are implemented with integrated passive devices (IPDs) on an output IPD die inside the device package 110. In such embodiments the second output inductive element may be implemented with bond wires inside the device package, with an integrated inductor on the output IPD die, with a discrete inductor, or with some combination thereof.

In some embodiments implementing the double T-match circuit 106 with bond wires inside the device package 110 and IPDs on an IPD die inside the package 110 may facilitate improved high frequency performance in the amplifier 100, particularly in high power applications. Specifically, with the inductive and capacitive elements inside the device package 110 the double T-match circuit 106 can better compensate for variations in intrinsic capacitance that can occur at high frequencies. This improved compensation of the intrinsic capacitance can result in more uniform output impedance over a relatively wide frequency bandwidth at relatively high frequencies. Thus, the amplifier 100 may be implemented to provide high power output over a relatively wide frequency bandwidth at relatively high frequencies.

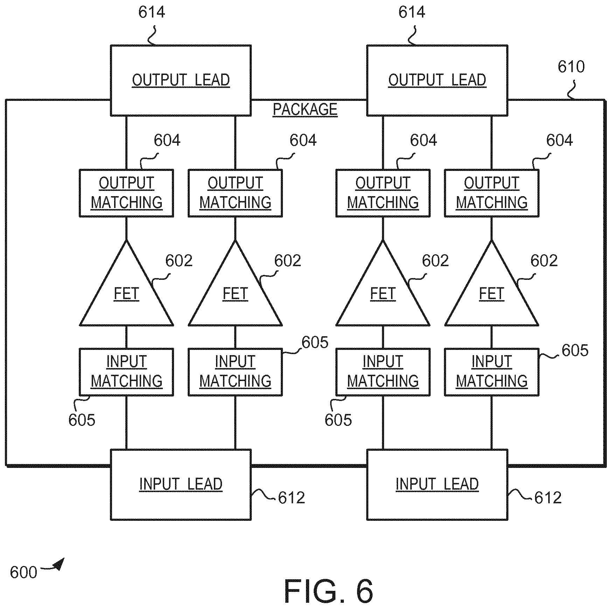

In one specific embodiment the transistor 102 has an intrinsic parasitic drain-source capacitance (C_{DS}). In such an embodiment the output matching network 104 can be configured to compensate for this intrinsic parasitic capacitance C_{DS} over a frequency range of about 3.1 to about 3.5 GHz, or over another frequency range. When implemented with a suitable transistor 102 (e.g., gallium nitride (GaN) field-effect transistors (FETs) the amplifier 100 may thus be implemented to provide high power output at over the frequency range of about 3.1 to about 3.5 GHz, or over another frequency range. One specific example of such a high power embodiment will be discussed in greater detail below with reference to FIG. 6.

In one specific embodiment, the first output capacitance can be implemented with one or more first metal-insulator-metal (MIM) capacitors and the second output capacitance is implemented with one or more second MIM capacitors. As will be described in greater detail below, the use of MIM capacitors to implement the various capacitances in the output matching network 104 can provide the needed capacitance values in close proximity to the transistor 102, and thus can facilitate a wide frequency bandwidth at fundamental frequencies.

In a variation on these embodiments, the output matching network 104 can also include a fourth output inductive element and a third output capacitance arranged as a bond-back circuit. In one embodiment the bond-back circuit is configured to resonate at a frequency between a fundamental frequency and a second harmonic frequency. Such a bond-back circuit can be implemented to further compensate for variations in intrinsic capacitance that can occur at high frequencies. In one specific embodiment, the fourth output inductive element is also implemented with a bond wire inside the device package 110, and the third output capacitance is implemented with an IPD on the output IPD die inside the device package 110.

In another variation on these embodiments, the amplifier 100 can also be configured to include an input matching network. In such an embodiment the input matching network can also include a double T-match circuit, where the double T-match circuit includes a first input inductive element, a second input inductive element, a third input inductive element, a first input capacitance, and a second input capacitance. Again, these inductive elements can be implemented with bond wires inside the device package 110, and the capacitive elements can be implemented with IPDs on an input IPD die inside the device package 110. Furthermore, in such embodiments the second input inductive element could also be implemented with an integrated inductor on the input IPD die.

Next, it should be noted that in many applications the amplifier 100 can be implemented to include multiple transistors 102 in parallel, and that these multiple transistors 102 can be implemented in multiple parallel amplification paths. An example of such an implementation will be described in detail with reference to FIG. 6 below. In such embodiments each amplification path can include at least one transistor 102 and at least one output matching network 104, with each output matching network 104 including a double T-match circuit 106. And again, such double T-match circuits 106 can each include a first output inductive element, a second output inductive element, and a third output inductive element implemented with bond wires inside the device package. Furthermore, such double T-match circuits 106 can each include a first output capacitance and a second output capacitance implemented with IPDs on one or more output IPD dies inside the device package 110.

Finally, it should be noted that amplifier 100 is a simplified representation of a portion of an amplifier, and in a more typical implementation the amplifier 100 would include additional features not illustrated in FIG. 1. Also, as used herein, the term "package" means a collection of structural components (e.g., including a flange or other package substrate) to which the primary electrical components (e.g., input and output leads, transistor dies, IPD dies, and various electrical interconnections) are coupled and/or encased. The package 110 is thus a distinct device that may be mounted to a printed circuit board (PCB) or other substrate that includes other devices. As specific examples, the package 110 can comprise an air cavity or overmolded package having a suitable package substrate, input leads, and output leads.

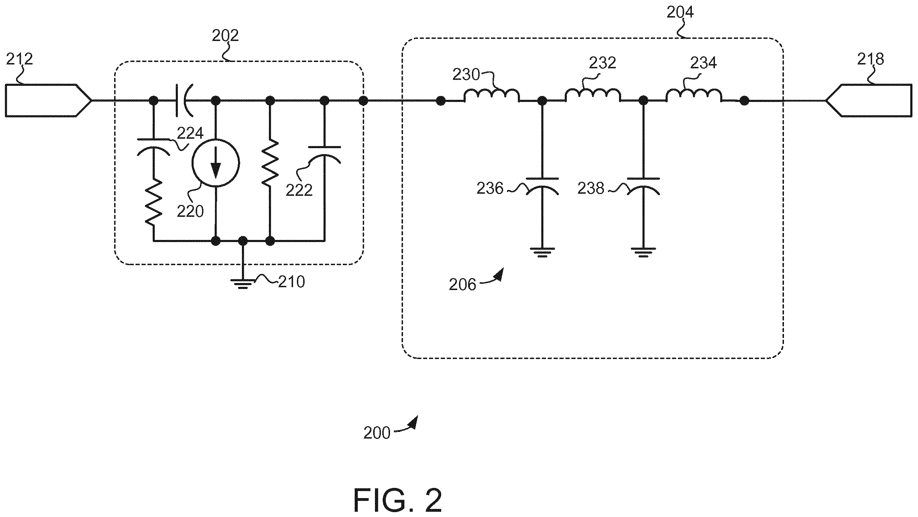

Turning now to FIG. 2, a circuit diagram representation of an exemplary amplifier 200 is illustrated. In this embodiment, the amplifier 200 again includes a transistor 202 and an output matching network 204. During operation, the amplifier 200 receives an input signal at a input terminal 212, and outputs an amplified signal through the output matching network 204 and to the load terminal 218. In a typical RF application the amplified signal would have a fundamental frequency (f₀), and would include signal energy at multiple harmonic frequencies, including signal energy at a second harmonic (2f₀) frequency and third harmonic (3f₀) frequency.

In FIG. 2 the transistor 202 is modelled as a current source 220 and associated resistances and capacitances. A control terminal (e.g., a gate) of the transistor 202 is coupled to the input terminal 212, a first current conducting terminal (e.g., a drain or source) is coupled to the matching network 204, and a second current conducting terminal (e.g., a source or drain) is coupled to ground (or another voltage reference). Included in this transistor model is an intrinsic input capacitance 224 and an intrinsic output capacitance 222. In a typical field-effect transistor implementation, the intrinsic output capacitance 222 would represent a drain-source capacitance commonly referred to as C_{DS}. In a typical bipolar transistor, the intrinsic output capacitance 222 would be a collector-emitter capacitance commonly referred to as C_{CE}.

It should be noted that at high frequencies such an intrinsic output capacitance 222 can experience significant variation over a wide frequency bandwidth in a way that cannot be compensated for using traditional techniques. This variation in intrinsic output capacitance 222 can thus effectively prevent traditional amplifiers from providing uniform output impedance over such wide frequency bandwidths.

Thus, in accordance with the embodiments described herein the output matching network 204 includes the double T-match circuit 206. The illustrated double T-match circuit 206 includes a first output inductive element 230, a second output inductive element 232, a third output inductive element 234, a first output capacitance 236, and a second output capacitance 238 arranged in a double T-match configuration. Each of the first output inductive element 230 and the third output inductive element 234 can be implemented with bond wires inside the device package, and each of the first output capacitance 236 and second output capacitance 238 can be implemented with one or more IPDs on an output IPD die that is mounted inside the device package. In one specific embodiment, the first output capacitance 236 can be implemented with one or more first metal-insulator-metal (MIM) capacitors and the second output capacitance 238 can be implemented with one or more second MIM capacitors. Furthermore, in such embodiments the second output inductive element 232 could be implemented with bond wires inside the device package, with an integrated inductor (e.g., in or on the output IPD die), or with some combination thereof.

As was described above, implementing the double T-match circuit 206 with bond wires inside the device package and IPDs on an IPD die inside the package can facilitate improved high frequency performance in the amplifier 200, particularly in high power applications. Specifically, with the inductive and capacitive elements inside the device package, the T-match circuit 206 can better compensate for variations in the intrinsic output capacitance 222 that can occur at high frequencies. This improved compensation of the intrinsic output capacitance 222 can result in more uniform output impedance over a relatively wide frequency bandwidth at relatively high frequencies.

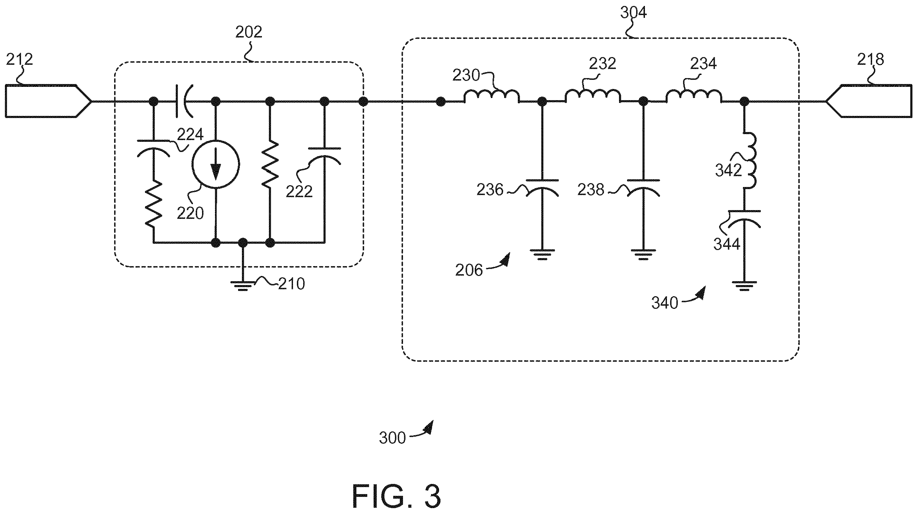

As was described above, in some embodiments a bond-back circuit can be included in the output matching network. Turning now to FIG. 3, a circuit diagram representation of another exemplary amplifier 300 is illustrated. In this illustrated embodiment, the amplifier 300 includes a transistor 202 and an output matching network 304.

In accordance with the embodiments described herein, the output matching network 304 again includes the double T-match circuit 206. However, in this embodiment the output matching network 304 additionally includes a bond-back circuit 340. Specifically, the bond-back circuit 340 includes a fourth output inductive element 342 and a third output capacitance 344 arranged in a bond-back configuration (i.e., wirebonded back into the package from an output lead). In such an embodiment, the fourth output inductive element 342 can also be implemented with bond wires inside the device package. Likewise, the third output capacitance 344 can also be implemented with one or more IPDs on an output IPD die that is mounted inside the device package. In one specific embodiment, the third output capacitance 344 can be implemented with one or more first MIM capacitors.

In one embodiment, the fourth output inductive element 342 and third output capacitance 344 can be implemented with values selected to resonate away from the fundamental frequency and at a frequency above the fundamental frequency but below the second harmonic frequency.

When so implemented the bond-back circuit 340 can improve the output impedance of the amplifier 200 at frequencies in the upper end of a desired frequency bandwidth.

With the double T-match circuit 206 and bond-back circuit 340 implemented with bond wires and IPDs inside the device package with the transistor 202, the output matching network 304 can facilitate improved high frequency performance in the amplifier 200, particularly in high power applications. Specifically, with the inductive and capacitive elements inside the device package the double T-match circuit 206 and bond-back circuit 340 can together better compensate for variations in the intrinsic output capacitance 222 that can occur at high frequencies.

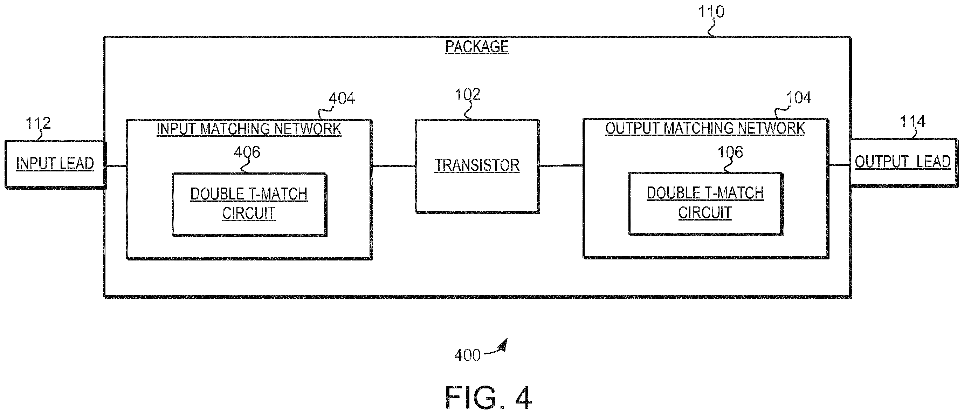

As was described above, in some embodiments the amplifier can also be configured to include an input matching network, and such an input matching network can also include a double T-match circuit. Turning now to FIG. 4, a schematic diagram of a portion of an exemplary amplifier 400 is illustrated. The amplifier 400 includes a first transistor 102, a first output matching network 104 that includes a double T-match circuit 106, a first input matching network 404 that includes a double T-match circuit 406, and a package 110 that includes a first input lead 112 and a first output lead 114.

In this illustrated embodiment, the transistor 102 is packaged with both the output matching network 104 and the input matching network 404. The transistor 102 is again formed on a transistor die, and that transistor die again typically includes a first input (e.g., control) terminal and a first output (e.g., current conducting) terminal. The output matching network 104 is coupled to the first output terminal of the amplifier transistor 102 and the input matching network 404 is coupled to the first input terminal.

Both the input matching network 404 and the output matching network 104 include double T-match circuits 106, 406. As described above, each double T-match circuit 106, 406 includes a first inductive element, a second inductive element, a third inductive element, a first capacitance, and a second capacitance. Furthermore, each of the first inductive element and the third inductive element are implemented with bond wires inside the device package 110, and each of the first capacitance and second capacitance are implemented with IPDs on one or more IPD dies inside the device package 110. In one specific embodiment, the first capacitance can be implemented with one or more first MIM capacitors and the second capacitance can be implemented with one or more second MIM capacitors. In such embodiments, the second inductive element could also be implemented with bond wires inside the device package, with an integrated inductor (e.g., on an IPD die), or with some combination thereof.

The addition of the input matching network 404 can further facilitate high frequency performance in the amplifier 400, particularly in high power applications. Specifically, the addition of the input matching network 404 can compensate for intrinsic capacitances at the input of the transistor 102. This compensation of the intrinsic input capacitance can thus also facilitate a relatively wide frequency bandwidth at relatively high frequencies.

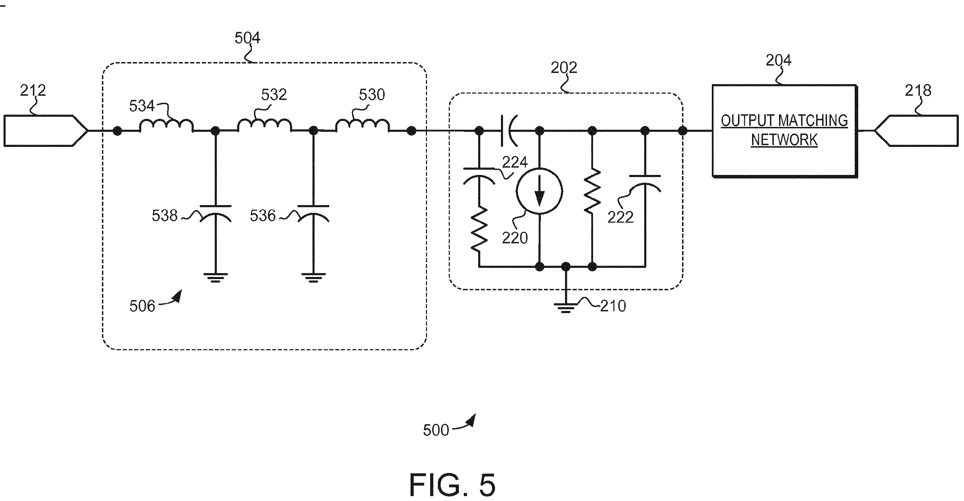

Turning now to FIG. 5, a circuit diagram representation of an exemplary amplifier 500 is illustrated. In this embodiment, the amplifier 500 includes a transistor 202, an input matching network 504, and an output matching network 204. During operation, the amplifier 200 receives an input signal at an input terminal 212, and outputs an amplified signal through the output matching network 204 and to the load terminal 218.

In FIG. 5, the transistor 202 is again modelled as a current source 220 and associated resistances and capacitances. Included in the transistor model is an intrinsic output capacitance 222 and an intrinsic input capacitance 224. In a typical field-effect transistor implementation, the intrinsic output capacitance 224 would be a gate-source capacitance commonly referred to as C_{GS}. In a typical bipolar transistor, the intrinsic input capacitance 224 would be a base-emitter capacitance commonly referred to as C_{BE}. It should be noted that at high frequencies such an intrinsic input capacitance 224 can experience significant variation over a desired frequency band in a way that cannot be compensated for using traditional matching techniques.

Thus, in accordance with the embodiments described herein the input matching network 504 includes the double T-match circuit 506. Specifically, the double T-match circuit 506 includes a first input inductive element 530, a second input inductive element 532, a third input inductive element 534, a first input capacitance 536, and a second input capacitance 538 arranged in a double T-match configuration. Each of the first input inductive element 530 and the third input inductive element 534 can be implemented with bond wires inside the device package, and each of the first input capacitance 536 and second input capacitance 538 can be implemented with one or more IPDs on an input IPD die that is mounted inside the device package. In one specific embodiment, the first input capacitance 536 can be implemented with one or more first MIM capacitors and the second input capacitance 538 can be implemented with one or more second MIM capacitors. In such embodiments the input inductive element 532 could be implemented with bond wires inside the device package, with an integrated inductor (e.g., on the input IPD die), or with some combination thereof.

Turning now to FIG. 6, a schematic view of an amplifier 600 in accordance with an exemplary embodiment is illustrated. In this example, amplifier 600 includes a package 610, four field effect transistors (FETs) 602, four output matching networks 604, four input matching networks 605, two input leads 612, and two output leads 614. In this example, amplifier 600 implements two amplification paths, with each amplification path including two input matching networks 605, two FETs 602, and two output matching networks 604, all encased together in one package 610. For example, the package 610 may include a substrate (e.g., substrate 708, described later, such as a copper flange or other substrate with a conductive top surface that serves as a ground plane) to which the various FET dies and IPDs are connected, along with conductive leads that are electrically isolated from the substrate and electrically connected to the circuitry contained within the package 610. The package may be an air-cavity package or a plastic encapsulated (overmolded) package.

In accordance with the embodiments described herein, each of the input and output matching networks 605, 604 are implemented to include a double T-match circuit. The double T-match circuit for each output matching network 604 and each input matching network 605 may include a first inductive element, a second inductive element, a third inductive element, a first capacitance, and a second capacitance. And as described above, each of the first inductive element, the second inductive element and the third inductive element can be implemented with bond wires inside the device package 610, and each of the first capacitance and second capacitance are implemented with IPDs on an IPD die inside the device package 610.

Such an implementation may provide the amplifier 600 with high power RF amplifier capability. As one example, when implemented with suitable FETs each amplification path may provide up to 420 W (watts) of power. Furthermore, when the two amplification paths are combined together (e.g., with an off package splitter at the input and an off package combiner at the output) the amplifier 700 can drive 750 W of power after accounting for losses in the off-package combiner.

It should be noted that the amplifier 600 illustrated in FIG. 6 is just one example, and many other device implementations are possible. For example, other amplifiers can include more or less amplification paths, transistors, and matching networks.

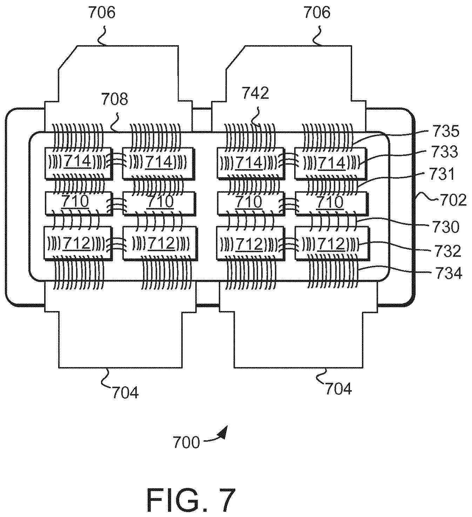

Turning now to FIG. 7, a top view of a portion of an amplifier 700 in accordance with an exemplary embodiment is illustrated. In this example, amplifier 700 again includes two amplification paths, with each amplification path including two input matching networks, two transistors, and two output matching networks, all encased together in one package 702.

The package 702 includes input leads 704, output leads 706, and a package substrate 708. The package substrate 708 can be a flange, a portion of a lead frame or another suitable substrate (e.g., PCB), to which semiconductor dies and other devices are mounted. In a typical embodiment, at least the top surface of the package substrate 708 is formed from a conductive material, and in some embodiments all of the package substrate 708 is formed from bulk conductive material. In addition to providing a mounting place the package substrate 708 may provide an electrical ground reference for the semiconductor devices. Finally, in some embodiments, the package substrate 708 may also provide a heat sink for the various semiconductor devices.

The package 702 also may include an isolation structure that is attached to the top surface of the package substrate 708 and that electrically isolates the package substrate 708 from the leads 704 and 706. This isolation structure may have a substantially rectangular shape or may have another suitable shape (e.g., annular ring, oval, and so on). Alternatively, in some embodiments the package 702 can include encapsulation material that instead provides such electrical isolation between the package substrate 708 and the leads 704 and 706.

The input leads 704 and output leads 706 are typically mounted on a top surface of the isolation structure on opposed sides of package. Thus, the input leads 704 and output leads 706 are elevated above the top surface of the package substrate 708 and are electrically isolated from the package substrate 708. Generally, the input leads 704 and output leads 706 are oriented to allow for attachment of bond wire arrays 734, 735, 742 between the input leads 704 and output leads 706 and elements within the package 702.

In this illustrated embodiment, a plurality of semiconductor device are mounted to the package substrate 708, where these semiconductor devices include input IPD dies 712, transistor dies 710, and output IPD dies 714. For example, these various dies may be coupled to the top surface of the package substrate 708 using conductive epoxy, solder, solder bumps, sintering, and/or eutectic bonds.

Each transistor die 710 is a semiconductor die that includes one or more transistors (e.g., transistor 102, 202, 602). For example, each transistor die 710 may include an integrated power FET, where each FET has a control terminal (e.g., a gate) and two current conducting terminals (e.g., a drain and a source). A control terminal of a FET within each transistor die 710 may be coupled to an input lead 704 through an input matching network (e.g., input matching network 404, 504, 605). In addition, one current conducting terminal (e.g., the drain) of a FET within each transistor die 710 is coupled to an output lead 706 through an output matching network (e.g., output matching network 104, 204, 304, 604). The other current conducting terminal (e.g., the source) of a FET within each transistor die 710 can be coupled through the die to the package substrate 708 (e.g., to ground).

As described above, each input IPD die 712 includes integrated capacitors that implement the capacitances of the input matching network (e.g., first input capacitance 536 and/or second input capacitance 538 of the input matching network 504). As one specific example, each of the capacitances of the input matching network can be implemented with one or more MIM capacitors that are integrally formed in the input IPD die 712. Finally, each output IPD die 714 includes integrated capacitors that implement the capacitances of the output matching network (e.g., first output capacitance 236, second output capacitance 238, and/or third output capacitance 344 of the output matching network 304). Again, as one specific example, each of the capacitances of the output matching network can be implemented with one or more MIM capacitors that are integrally formed in the output IPD die 714.

Additionally, in some embodiments the input IPD dies 712 also include one or more integrated inductors. Likewise, in some embodiments the output IPD die 714 can also include one or more integrated inductors. In such embodiments the second input inductive element and/or the second output inductive element could each be implemented all or in part with an integrated inductor on the associated IPD die 712, 714.

Also included in amplifier 700 are various bond wire arrays 730, 731, 732, 733, 734, 735, 742, which correspond to inductances 530, 230, 532, 232, 534, 234, and 342, respectively. Each of the bond wire arrays 730, 731, 732, 733, 734, 735, 742 includes one or more closely-spaced parallel bond wires that are connected to appropriate leads, terminals, pads, or other connection features on the dies and other elements. For example, bond wire arrays 734 are used to provide electrical connection between the input IPD dies 712 and the input leads 704, bond wire arrays 730 are used to provide electrical connection between the input IPD dies 712 and the control terminals of the transistor dies 710, bond wire arrays 731 are used to provide electrical connection between the output IPD dies 714 and the current conducting terminals of the transistor dies 710, and bond wire arrays 735 are used to provide electrical connection between the output IPD dies 714 and the output leads 706. Finally, bond wire arrays 732 and 733 can provide electrical connections between elements on the same die, such as between integrated passive devices (e.g., MIM capacitors) on the input IPD dies 712 and the output IPD dies 714.

Additionally, all or part of the bond wire arrays 730-735, 742 can be used to implement the various inductive elements of the matching networks. For example, the bond wire arrays 730, 732, 734 can be used to implement the inductive elements of the input matching network (e.g., first input inductive element 530, second input inductive element 532, third input inductive element 534 of the input matching network 504). Likewise, the bond wire arrays 731, 733, 735, 742 can be used to implement the inductive elements of the output matching network (e.g., first output inductive element 230, second output inductive element 232, third output inductive element 234, and fourth output inductive element 342 of the output matching network 204, 304).

It should be noted that the number and arrangement of bond wires would be selected based on the power handling requirements and the desired inductances of the bond wires. Thus, for connections that require more power handling ability more bond wires can be provided. Further, although the transistors are illustrated on four separate transistor dies 710, an alternate embodiment may have multiple transistors implemented on a single transistor die 710. Further, each "transistor" may correspond to a single stage amplifier (i.e., comprising a single power transistor) or to a multiple-stage amplifier (e.g., a two stage amplifier with a driver amplifier (driver transistor) connected in series with a final-stage amplifier (final-stage transistor)).

Not shown in FIG. 7 is the cover or cap of the package 702 that encases elements inside. As noted above, the package 702 can be implemented with a variety of package types, including air cavity packages and overmolded packages. In general, in air cavity packages the various other components are located within an enclosed air cavity. This air cavity is bounded by package substrate 708, isolation structure and a cap (not shown) overlying and in contact with the isolation structure and leads 704 and 706. Similarly, in an overmolded package the various components within the package are encapsulated with a non-conductive molding compound.

It should finally be noted that the amplifier 700 illustrated in FIG. 7 is just one example, and many other packaged device implementations are possible. For example, other amplifiers can include more or less amplification paths with the package 702. Other amplifiers can also include more or fewer transistor dies 710 and IPD dies 712, 714 within the package 702. Other amplifier packages 702 can also include more or fewer leads, including bias leads for coupling to external bias circuits.

As was noted above, in the various embodiments the capacitances of the input matching network and output matching network can be implemented a type of integrated passive device called metal-insulator-metal (MIM) capacitors. In general, MIM capacitors are integrated capacitors formed from patterned conductive and dielectric layers on a semiconductor substrate. Portions of the conductive layers corresponding to electrodes are aligned with each other and separated (electrically and physically) from each other by dielectric layers. Specifically, the conductive electrodes are formed from patterned portions of the conductive layers of a build-up structure, where the build-up structure includes alternating dielectric and conductive layers. Each electrode may include a portion of a single conductive layer or multiple conductive layers, where the patterned portions of the conductive layers for a single electrode can electrically connected using conductive vias, and the conductive layers for the two electrodes are interleaved with each other in an alternating arrangement. The amount of capacitance provided by a MIM capacitor can thus be determined by the patterned size and shape of the conductive layers (electrodes), the dielectric constant and thickness of the intervening dielectric layers, and the number of conductive layers electrically connected together to form each capacitor electrode. Furthermore, in a typical embodiment a number of MIM capacitors will be formed on an IPD die and a selected subset of those MIM capacitors electrically coupled together to provide a capacitive element with the desired capacitance value. Thus, the various input and output matching capacitances described above (e.g., first input capacitance 536, second input capacitance 538 of the input matching network 504, and first output capacitance 236, second output capacitance 238, and third output capacitance 344 of the output matching network 304) can each be implemented with one or more MIM capacitors electrically connected together to provide the desired capacitance value.

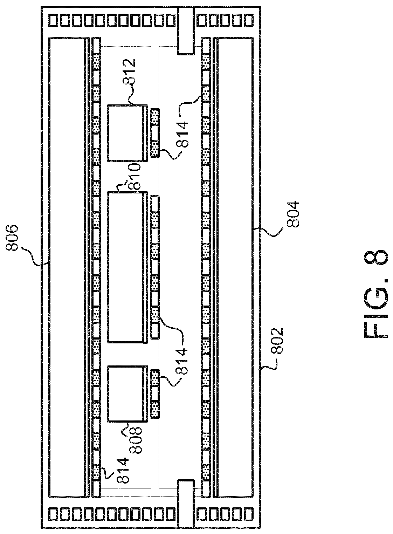

Turning now to FIG. 8, a top view of an integrated passive device (IPD) die 802 is illustrated. The IPD die 802 includes MIM capacitors 804, 806, 808, 810, and 812 integrally formed in a build-up structure on a semiconductor substrate (e.g., a silicon, silicon-on-insulator, gallium nitride, gallium arsenide, or other semiconductor substrate). Each of these MIM capacitors is an integrated device that is fabricated from patterned alternating conductive and dielectric layers, where sets of conductive layers correspond to first and second electrodes of each MIM capacitor. The first electrodes of the MIM capacitors 804, 806, 808, 810, and 812 are electrically connected to conductive pads that are exposed at the top surface of the IPD die 802 (e.g., for connection to bond wire arrays 730-735, 742), and the second electrodes of the MIM capacitors 804, 806, 808, 810, and 812 are electrically connected to the bottom surface of the IPD die 802 (e.g., for connection with a ground reference, such as a surface of package substrate 708). Furthermore, each MIM capacitor 804, 806, 808, 810, and 812 includes cells 814 that can be used to precisely tune the capacitance value. Thus, the capacitance of each MIM capacitor 804, 806, 808, 810, and 812 can be precisely tuned to a desired value by connecting to selected cells 814. Additionally, multiple MIM capacitors 804, 806, 808, 810, and 812 can be combined to provide one capacitance value.

For example, in one embodiment the first input capacitance 536 of input matching network 504 can be implemented with MIM capacitor 804. Likewise, the second input capacitance 538 can be implemented with MIM capacitor 506. Similarly, in a separate IPD, the first output capacitance 236 of output matching network 304 can be implemented with MIM capacitor 804. Likewise, the second output capacitance 238 can be implemented with MIM capacitor 806. Finally, the third output capacitance 344 can be implemented with one or more of MIM capacitors 808, 810 and/or 812. Of course, this is just one example and other implementations are possible.

As was described above, the amplifiers described herein (e.g., amplifier 100, 200, 300, 400, 500, 600 and 700) can be implemented to include one or more matching networks in the device package with the transistors. Implementing these matching networks inside the device package can facilitate relatively high power and high efficiency at high operational frequencies and over wide frequency bandwidths. To implement these matching networks with inductive and capacitive elements arranged in double T-match configuration, the values of the individual inductive and capacitive elements can be selected to provide the desired input and/or output impedances. Additionally, the values of the individual inductive and capacitive elements can be selected to provide a desired bandwidth and Q factor for the amplifier. A variety of circuit design techniques and tools can be selected to determine the values of the individual inductive and capacitive elements based the desired performance characteristics.

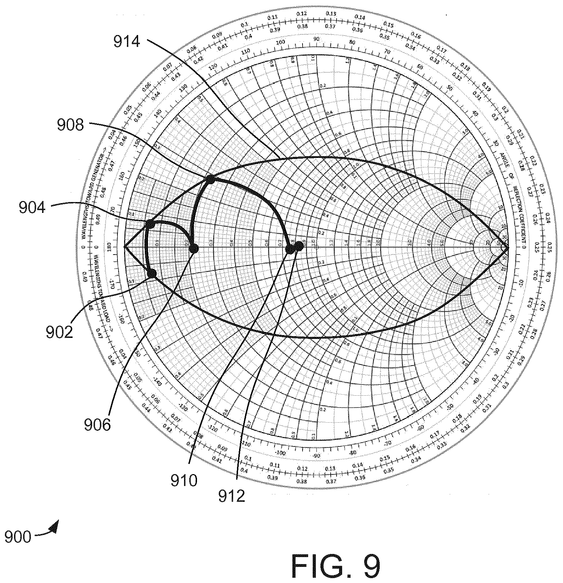

One specific example of a technique for determining appropriate values for the inductive and capacitive elements will now be discussed with reference to a Smith Chart 900 illustrated in FIG. 9. It should be noted however, that the Smith Chart is simply a tool for illustrating the impedance effects of inductive and capacitive elements, and that in most applications computer aided techniques for modeling and determining circuit values will be used and the use of the Smith Chart is thus merely representative of the concepts involved and completely optional.

In general, this technique starts with the predicted output impedance of the transistor at the current conducting terminal (e.g., drain) and the desired Q factor of the final device based on bandwidth requirements. In Smith Chart 900 the point 902 represents an exemplary predicted output impedance of a typical suitable GaN FET transistor (e.g., transistor 202).

Starting with the predicted output impedance of such a transistor, an inductance value for the first inductive element of the output impedance matching network (e.g., inductor 230 of network 204) is tuned by selectively increasing and decreasing the value until the resulting impedance on the Smith Chart meets a value that provides the desired quality value (Q). In Smith Chart 900, the Q curve 914 represents an exemplary Q value of 1.7, and point 904 represents an exemplary resulting impedance that meets the upper half of the Q curve 914.

Next, a capacitance value for the first capacitance element of the output impedance matching network (e.g., capacitor 236 of network 204) is tuned by increasing and decreasing the value until the resulting impedance on the Smith Chart returns to about the horizontal real impedance line. This will result in an increasing of impedance to a higher value at this node. In Smith Chart 900 the point 906 represents an exemplary resulting impedance increase from ∼2.6 ohms to ∼10 ohms.

Next, an inductance value for the second inductive element of the output impedance matching network (e.g., inductor 232 of network 204) is tuned by increasing and decreasing the value until the resulting impedance on the Smith Chart meets again meets the desired Q value. In Smith Chart 900 the point 908 represents an exemplary resulting impedance on the upper half of a Q curve 914. It should be noted however that in some cases it may be desirable to configure the second output impedance to shift the resulting impedance a lesser amount. Specifically, reducing the effect of the second output inductance in such an embodiment may provide a higher bandwidth in some implementations. For example, second output impedance can instead be selected to provide a resulting impedance that provides a Q value equal to 1.0 instead of 1.7.

Next, a capacitance value for the second capacitance element of the output impedance matching network (e.g., capacitor 238 of network 204) is tuned by increasing and decreasing the value until the resulting impedance on the Smith Chart again returns to about the horizontal real impedance line. This will again result in an increasing in impedance to a higher value. In Smith Chart 900 the point 910 represents an exemplary resulting impedance with an increase from ~ 10 ohms to ∼40 ohms.

Next, an inductance value for the third inductive element of the output impedance matching network (e.g., inductor 234 of network 204) is tuned by increasing and decreasing the value until the resulting impedance on the Smith Chart meets the desired value. Typically, the third output inductance value will be relatively small, and thus the impedance on the Smith chart will move a relatively small amount. In Smith Chart 900 the point 912 represents an exemplary resulting small impedance increase.

Next, the fourth output inductance value and the third output capacitance value of the bond-back circuit can be calculated to provide an inductor/capacitor (LC) resonant circuit that resonates at a frequency slightly below the second harmonic frequency.

The result of this process is the determination of inductance and capacitive values for the elements in the double T-match circuit that provide the desired output impedance and effectively compensate for the intrinsic capacitances at high frequencies and over a wide frequency bandwidth.

It should be noted that a similar process can be used to select the inductive and capacitive values used to implement an input matching network (e.g., input matching network 504).

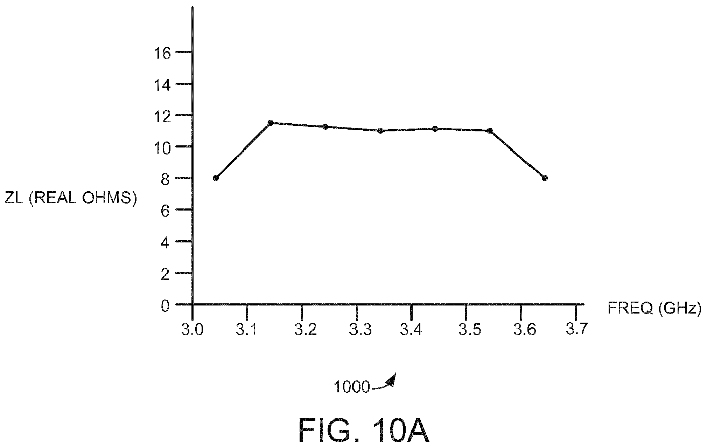

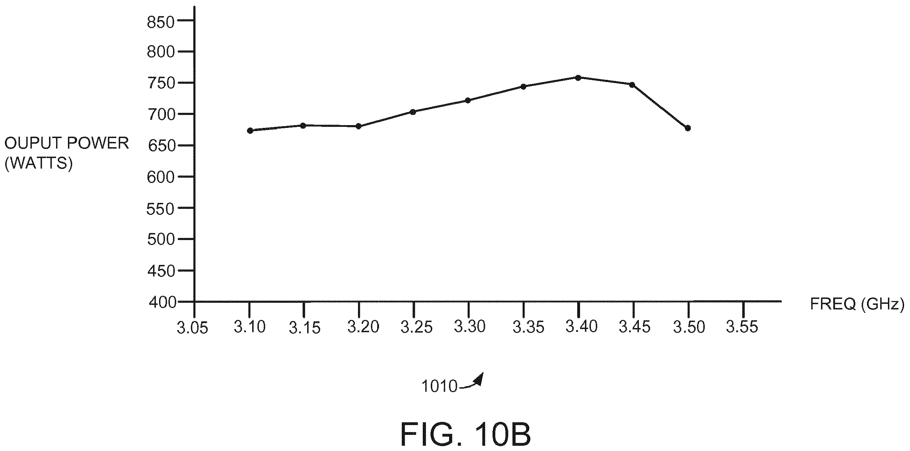

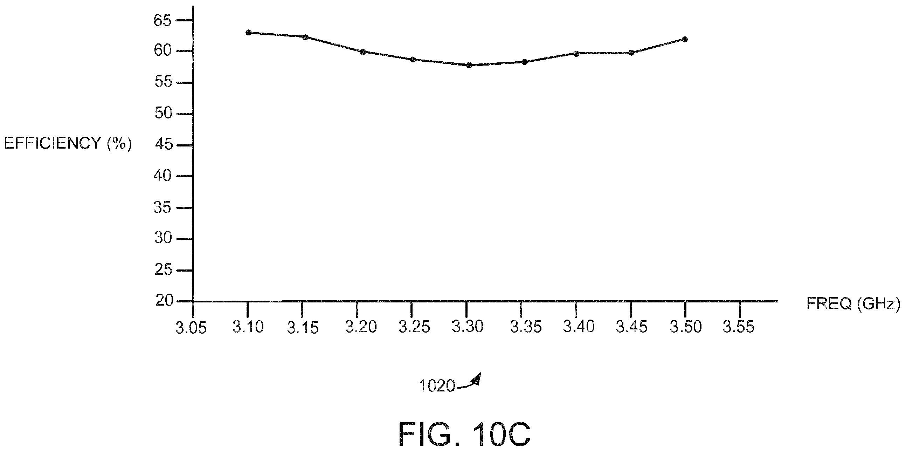

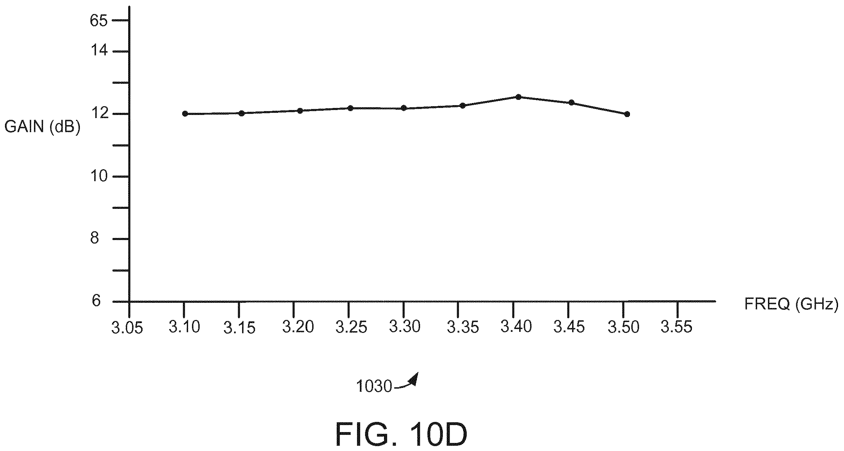

Turning now to FIGS. 10A, 10B, 10C and 10D, example operational parameters for an amplifier in accordance with the embodiments described herein are illustrated. Specifically, in this example, the exemplary amplifier is implemented as shown in FIG. 6, and thus includes four FETs arranged in two amplification paths.

Turning specifically now to FIG. 10A, a graph 1000 illustrates exemplary load impedances for an amplifier in accordance with this embodiment. Specifically, the graph 1000 shows that the matching network with inductive and capacitive elements arranged in double T-match configuration can compensate for variations in the intrinsic parasitic capacitance C_{DS} to provide a substantially uniform real load impedance between about 3.1 to about 3.5 GHz.

Turning now to FIG. 10B, a graph 1010 illustrates exemplary output power (in watts) for an amplifier in accordance with this embodiment. Specifically, the graph 1010 shows that such an amplifier may provide an output power between about 650 and 750 watts at frequencies between about 3.1 to about 3.5 GHz.

Turning now to FIG. 10C, a graph 1020 illustrates exemplary efficiency (as a percentage) of an amplifier in accordance with this embodiment. Specifically, the graph 1020 shows that the amplifier may provide an efficiency of about 60% at frequencies between about 3.1 to about 3.5 GHz.

Turning now to FIG. 10D, a graph 1030 illustrates exemplary gain (in decibels (dB)) of an amplifier in accordance with this embodiment. Specifically, the graph 1030 shows that the amplifier may provide a gain of about 12 dB at frequencies between about 3.1 to about 3.5 GHz.

Thus, the examples shown in FIGS. 10A, 10B, 10C and 10D show that an exemplary amplifier may provide a power output of up to 750 W with a gain of 12 dB and an efficiency of over 60% in operation over a frequency bandwidth of about 3.1 to about 3.5 GHz. It should be noted however that this is just one example, and other implementations of the embodiments described herein may not meet any or all of these device parameters.

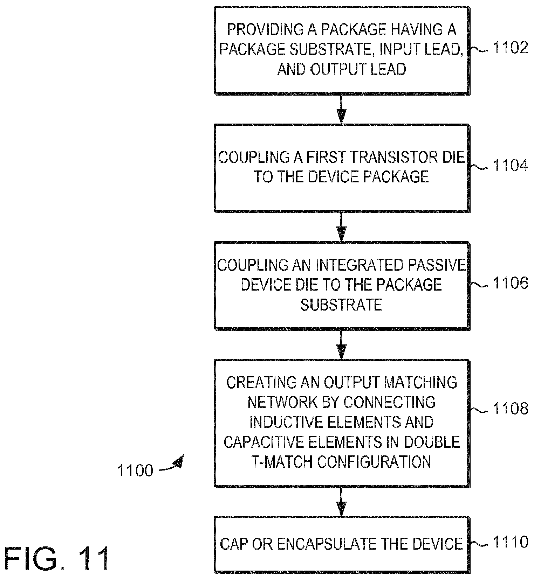

Turning now to FIG. 11, a flowchart illustrates a method 1100 for fabricating a packaged RF power amplifier device (e.g., amplifier 100, FIG. 1) that includes an output matching network (e.g., output matching network 104). The output matching network is implemented to include inductive and capacitive elements in a double T-match circuit (e.g., double T-match circuit 106), where at least some of the inductive elements (e.g., inductive elements 230, 234) are implemented with bond wires (e.g., bond wire arrays 731, 735), other inductive elements (e.g., inductive element 232) are implemented with bondwires or integrated inductances (e.g., integrated in IPD dies 714, 802), and the capacitive elements are implemented with integrated capacitors (e.g., MIM capacitors 804, 806, 808, 810, and 820 in IPD dies 714, 802). In such implementations the double T-match configuration of the matching network can be fully implemented inside the package, and may provide the amplifier with good performance at relatively high frequencies and over a relatively wide bandwidth.

The method 1100 may begin, in block 1102, by providing a package having a package substrate, input lead, and output lead (e.g., package 702, package substrate 708, input leads 704, output leads 706). In block 1104 a first transistor die (e.g., transistor die 710) is coupled to the device package. This coupling can be accomplished by affixing the transistor die to package substrate (e.g., package substrate 708) using conductive epoxy, solder, solder bumps, sintering, and/or eutectic bonds, to give non-limiting examples.

In block 1106 an integrated passive device die (e.g., output IPD die 714) is coupled to the device substrate between the transistor die and the output lead. As described above, the output IPD die includes integrated passive devices, such as integrated MIM capacitors (e.g., MIM capacitors 804, 806, 808, 810, and 820).

In block 1108 an output matching network is created by connecting the inductive elements and capacitive elements in a double T-match configuration. As described above, wire bonds (e.g., wire bond arrays 731, 735) can be used to provide electrical connections between the integrated capacitive elements, the transistor, and the package leads. When so implemented, these wire bonds also provide at least some of the inductive elements of a double T-match circuit (e.g., double T-match circuit 106). Specifically, the wire bonds are implemented to provide at least the first output inductive element and third output inductive elements (e.g., first output inductive element 230 and third output inductive element 234). Furthermore, in some embodiment wire bonds are implemented to provide the second output inductive element (e.g., second output inductive element 232), although the second output inductive element could be provided using an integrated inductor in the IPD, as well. Ultimately, the wire bonds connect to the first output capacitance and the second output capacitance (e.g., first output capacitance 236, second output capacitance 238) to configure the output impedance matching network in a double T-match configuration.

In block 1110 the device is capped (e.g., for an air cavity package) or encapsulated (e.g., with mold compound for an overmolded package). The resulting packaged amplifier device may then be incorporated into a larger electrical system.

It should be noted that the method 1100 can be expanded to also provide an input matching network (e.g., input matching network 504) in the amplifier. In such an embodiment, block 1106 and 1108 would be repeated to couple an input IPD die (e.g., input IPD die 712) to the package substrate (e.g., package substrate 708) and to create an input matching network with bond wires and the integrated capacitors on the IPD die.

The various embodiments incorporate an internal output load impedance matching configuration based on a double T-match combined with a bond-back wire topology to compensate the transistor device (e.g., GaN device) internal C_{DS} parasitic capacitor across the band (e.g., from 3.1-3.5 GHz operation, or across other bands). Unique IPD layout designs facilitate implementation of the technique. In addition, embodiments include an input matching circuit with a double T-matched topology for a broadband input match.

At high frequency operations, the various embodiments facilitate the achievement of bandpass filter characteristic of FET internal matching networks. In addition, at microwave and millimeter-wave frequency operations, the wire bond inductors of the various embodiments function as a series resonator with a combination of IPD shunt capacitors implemented in T-match configurations. Multiple T-match sections can be added to achieve broad bandwidth response. The matching filter network poles and zeros can be set-up independently. For example, the first zero may be set below the lower end of the band (e.g., below 3 GHz) and the second zero may be set above the upper end of the band (e.g., above 3.5 GHz), while resonant poles may be selected per the desired frequency band. The bond-back bond wires (e.g., bond wires 742) may be configured to resonate with the shunt capacitor to which they are connected (e.g., capacitor 344) close to a second harmonic of the fundamental frequency of operation, which may help to improve impedance at the upper end of the band.

The various embodiments include the step impedance of a low Q matching transformation topology at the chip level to scale up and achieve near-uniform constant load impedance across the band. In addition, the bond-back bond wires (e.g., bond wires 742 corresponding to inductance 342) also may help to improve impedance at the higher end of the band (e.g., at 3.5 GHz or more). In addition, unique layouts for input and output IPD dies (e.g., IPD dies 712, 714, 802) enable a scaling-up of the broadband uniform load impedance in a step transformation based on multi-section matching networks per the desired bandwidth. The IPD dies facilitate implementation of the design concepts in a compact package.

With respect to the transistor dies, it has been observed that GaN technology has a broadband characteristic in nature due to the GaN transistor's lower intrinsic drain-source capacitance, high power density per unit area, and high frequency operation, when compared with conventional silicon-based LDMOS transistors. Embodiments of the present invention facilitate the presentation of a uniform constant ZL load-impedance over a broadband range for potentially achieving maximum power, gain and drain efficiency performance.

Device level implementations (i.e., implementations within a packaged device, such as amplifier 700) of multi-section L-match, pi-match or T-match network topologies have not been utilized for high power design internal matching at very high frequencies (e.g., frequencies above 3 GHz) due to previous technological limitations that are overcome with embodiments of the present invention. In addition, embodiments of the present invention compensate for high parasitics exhibited by the physical elements connected to the transistor die at high frequencies (e.g., frequencies above 3 GHz), which parasitics may otherwise result in variable load impedance across the band and map a large trajectory on the Smith Chart.

In one embodiment an amplifier is provided, the amplifier comprising: a device package including at least a first output lead and at a first input lead, the device package encasing: a first transistor die, wherein the first transistor die includes a first transistor, a first input terminal, and a first output terminal; and a first output matching network coupled between the first output terminal and the first output lead, the first output matching network including a first output inductive element, a second output inductive element, a third output inductive element, a first output capacitance, and a second output capacitance arranged in a double T-match configuration, wherein each of the first output inductive element and the third output inductive element are implemented with bond wires inside the device package, and wherein the first output capacitance and second output capacitance are implemented with integrated passive devices (IPDs) on an output IPD die inside the device package.

In another embodiment a packaged RF amplifier is provided, the packaged RF amplifier comprising: a package substrate; a first input lead coupled to the package substrate; a first output lead coupled to the package substrate; a first transistor die coupled to the package substrate, wherein the first transistor die includes a first transistor, a first input terminal, and a first output terminal; a first input matching network coupled between the first input lead and the first input terminal, the first input matching network including: a first input inductive element, a second input inductive element, a third input inductive element, a first input capacitance and a second input capacitance arranged in a double T-match configuration, wherein each of the first input inductive element, the second input inductive element and the third input inductive element are implemented with bond wires, and wherein the first capacitance and second capacitance are implemented with integrated metal-insulator-metal (MIM) capacitors formed on an input integrated passive device (IPD) die coupled to the package substrate; and a first output matching network coupled between the first output terminal and the first output lead, the first output matching network including: a first output inductive element, a second output inductive element, a third output inductive element, a first output capacitance and a second output capacitance arranged in a double T-match configuration, wherein each of the first output inductive element, the second output inductive element and the third output inductive element are implemented with bond wires, and wherein the first output capacitance and second output capacitance are implemented with integrated metal-insulator-metal (MIM) capacitors formed on an output integrated passive device (IPD) die coupled to the package substrate.

In another embodiment a method of manufacturing a radio frequency (RF) amplifier device is provided, the method comprising the steps of: coupling a first input lead to a package substrate; coupling a first output lead to the package substrate; coupling a first transistor die coupled to the package substrate, wherein the first transistor die includes a first transistor, a first input terminal, and a first output terminal; coupling an integrated passive device to the package substrate between the transistor die and the first output lead, wherein the integrated passive device includes a first output capacitance and a second output capacitance, wherein the first output capacitance includes one or more first capacitors that are integrally formed with the integrated passive device and the second output capacitance includes one or more second capacitors that are integrally formed with the integrated passive device; and creating an output matching network coupled between the first output terminal and the first output lead by connecting a first output inductive element, a second output inductive element, and a third output inductive element to the first output capacitance and the second output capacitance in a double T-match configuration, wherein each of the first output inductive element and the third output inductive element are implemented with bond wires.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. An amplifier comprising:
a device package including at least a first output lead and at a first input lead, the device package encasing:
a first transistor die, wherein the first transistor die includes a first transistor, a first input terminal, and a first output terminal; and
a first output matching network coupled between the first output terminal and the first output lead, the first output matching network including a first output inductive element, a second output inductive element, a third output inductive element, a first output capacitance, and a second output capacitance arranged in a double T-match configuration, wherein each of the first output inductive element and the third output inductive element are implemented with bond wires inside the device package, and wherein the first output capacitance and second output capacitance are implemented with integrated passive devices (IPDs) on an output IPD die inside the device package.

2. The amplifier of claim 1, wherein the double T-match configuration comprises the first output inductive element, the second output inductive element, and the third output inductive element in series, the first output capacitance configured in a first shunt and between the first output inductive element and the second output inductive element, and the second output capacitance configured in a second shunt and between the second output inductive element and the third output inductive element.

3. The amplifier of claim 1, wherein the second output inductive element is implemented with bond wires inside the device package.

4. The amplifier of claim 1, wherein the second output inductive element is implemented with an integrated inductor on the output IPD die.

5. The amplifier of claim 1, wherein the first output capacitance is implemented with one or more first metal-insulator-metal (MIM) capacitors and wherein the second output capacitance is implemented with one or more second MIM capacitors.

6. The amplifier of claim 1, wherein the first output matching network further comprises a fourth output inductive element and a third output capacitance arranged in bond-back configuration, and wherein the fourth output inductive element is implemented with a bond wire inside the device package and wherein the third output capacitance is implemented with an integrated passive device (IPD) on the output IPD die inside the device package.

7. The amplifier of claim 6, wherein the fourth output inductive element and the third output capacitance are configured to resonate at a frequency above a fundamental frequency and below a second harmonic frequency.

8. The amplifier of claim 1, further comprising an input matching network coupled between the first input terminal and the first input lead, the input matching network including a first input inductive element, a second input inductive element, a third input inductive element, a first input capacitance and a second input capacitance arranged in a double T-match configuration, wherein each of the first input inductive element and the third input inductive element are implemented with bond wires inside the device package, and wherein the first capacitance and second capacitance are implemented with integrated passive devices (IPDs) on an input IPD die inside the device package.

9. The amplifier of claim 8, wherein the second input inductive element is implemented with bond wires inside the device package.

10. The amplifier of claim 8, wherein the second input inductive element is implemented with an integrated inductor on the input IPD die.

11. The amplifier of claim 1, wherein the transistor comprises a gallium nitride (GaN) field-effect transistor (FET).

12. The amplifier of claim 1, further comprising:
a second output lead on the device package;
a second transistor die, wherein the second transistor die includes a second transistor, a second input terminal, and a second output terminal; and
a second output matching network coupled between the second output terminal and the second output lead, the second output matching network including a first output inductive element, a second output inductive element, a third output inductive element, a first output capacitance and a second output capacitance arranged in a double T-match configuration, wherein each of the first output inductive element, the second output inductive element and the third output inductive element are implemented with bond wires inside the device package, and wherein the first output capacitance and second output capacitance are implemented with integrated passive devices (IPDs) on a second output IPD die inside the device package.

13. A packaged radio frequency (RF) amplifier comprising:
a package substrate;
a first input lead coupled to the package substrate;
a first output lead coupled to the package substrate;
a first transistor die coupled to the package substrate, wherein the first transistor die includes a first transistor, a first input terminal, and a first output terminal;
a first input matching network coupled between the first input lead and the first input terminal, the first input matching network including:
a first input inductive element, a second input inductive element, a third input inductive element, a first input capacitance and a second input capacitance arranged in a double T-match configuration, wherein each of the first input inductive element, the second input inductive element and the third input inductive element are implemented with bond wires, and wherein the first capacitance and second capacitance are implemented with integrated metal-insulator-metal (MIM) capacitors formed on an input integrated passive device (IPD) die coupled to the package substrate; and
a first output matching network coupled between the first output terminal and the first output lead, the first output matching network including:
a first output inductive element, a second output inductive element, a third output inductive element, a first output capacitance and a second output capacitance arranged in a double T-match configuration, wherein each of the first output inductive element, the second output inductive element and the third output inductive element are implemented with bond wires, and wherein the first output capacitance and second output capacitance are implemented with integrated metal-insulator-metal (MIM) capacitors formed on an output integrated passive device (IPD) die coupled to the package substrate.

14. The packaged RF amplifier of claim 13, wherein the first output matching network further comprises a fourth output inductive element and a third output capacitance arranged in bond-back configuration, and wherein the fourth output inductive element is implemented with bond wires, and wherein the third output capacitance is implemented with one or more MIM capacitors on the output IPD die coupled to the package substrate.

15. A method of manufacturing a radio frequency (RF) amplifier device, the method comprising the steps of:
coupling a first input lead to a package substrate;
coupling a first output lead to the package substrate;
coupling a first transistor die coupled to the package substrate, wherein the first transistor die includes a first transistor, a first input terminal, and a first output terminal;
coupling an integrated passive device to the package substrate between the transistor die and the first output lead, wherein the integrated passive device includes a first output capacitance and a second output capacitance, wherein the first output capacitance includes one or more first capacitors that are integrally formed with the integrated passive device and the second output capacitance includes one or more second capacitors that are integrally formed with the integrated passive device; and
creating an output matching network coupled between the first output terminal and the first output lead by connecting a first output inductive element, a second output inductive element, and a third output inductive element to the first output capacitance and the second output capacitance in a double T-match configuration, wherein each of the first output inductive element and the third output inductive element are implemented with bond wires.
